(19) Europäisches Patentamt

European Patent Office

Office européen des brevets

(11) **EP 0 952 661 B1**

(12) **EUROPÄISCHE PATENTSCHRIFT**

(45) Veröffentlichungstag und Bekanntmachung des Hinweises auf die Patenterteilung:
**21.06.2006 Patentblatt 2006/25**

(51) Int Cl.:
***H02M 3/07*** *(2006.01)*

(21) Anmeldenummer: **99106439.5**

(22) Anmeldetag: **29.03.1999**

(54) **Schaltungsanordnung für eine Ladungspumpe und Spannungsreglerschaltung mit einer derartigen Schaltungsanordnung**

Circuit for a charge pump and voltage regulator with such a circuit

Circuit pour une pompe de charge et régulateur de tension comportant un tel circuit

(84) Benannte Vertragsstaaten:
**DE FR IT**

(30) Priorität: **24.04.1998 DE 19818465**

(43) Veröffentlichungstag der Anmeldung:
**27.10.1999 Patentblatt 1999/43**

(60) Teilanmeldung:
**05001856.3 / 1 528 662**

(73) Patentinhaber: **Infineon Technologies AG
81669 München (DE)**

(72) Erfinder: **Feldtkeller, Martin
81543 München (DE)**

(74) Vertreter: **Bickel, Michael
Westphal & Partner
Mozartstrasse 8
80336 München (DE)**

(56) Entgegenhaltungen:
EP-A- 0 700 146    DE-A- 4 439 787
US-A- 4 301 501    US-A- 5 654 628

• WAI LAU ET AL: "An integrated controller for a high frequency buck converter" POWER ELECTRONICS SPECIALISTS CONFERENCE, 1997. PESC '97 RECORD., 28TH ANNUAL IEEE ST. LOUIS, MO, USA 22-27 JUNE 1997, NEW YORK, NY, USA,IEEE, US, 22. Juni 1997 (1997-06-22), Seiten 246-254, XP010241555 ISBN: 0-7803-3840-5

## Beschreibung

Die vorliegende Erfindung betrifft eine Schaltungsanordnung für eine Ladungspumpe sowie einen Spannungsregler, bei dem eine derartige Schaltungsanordnung in einer Ladungspumpe zum Einsatz kommt.

Zum Betrieb verschiedener elektronischer Schaltungen ist der Einsatz von Spannungsreglern erforderlich, die für eine möglichst störungsfreie und stabilisierte Betriebsspannung sorgen. So benötigen beispielsweise elektronische Geräte in Kraftfahrzeugen Spannungsregler, die aus der von Störungen überlagerten Betriebsspannung (zwischen 12 und 15 V) eine störungsfreie stabilisierte Ausgangsspannung (in der Größenordnung von ca. 5 V) erzeugen. Die in diesem Anwendungsgebiet eingesetzten Spannungsregler müssen eine sehr niedrige Stromaufnahme (<100 $\mu$A) haben, da die meisten elektronischen Kraftfahrzeugsysteme auch dann an das Bordnetz des Kraftfahrzeugs angeschlossen bleiben, falls das Kraftfahrzeug abgestellt wird, wobei jedoch die Autobatterie nicht entladen werden darf. Des weiteren sollen die verwendeten Spannungsregler einen möglichst geringen Spannungsabfall zwischen der Eingangs- und Ausgangsspannung ermöglichen, damit auch bei Einbrüchen der Versorgungs- bzw. Bordnetzspannung auf beispielsweise 5,5 V eine noch ausreichend hohe Ausgangsspannung aufrechterhalten werden kann.

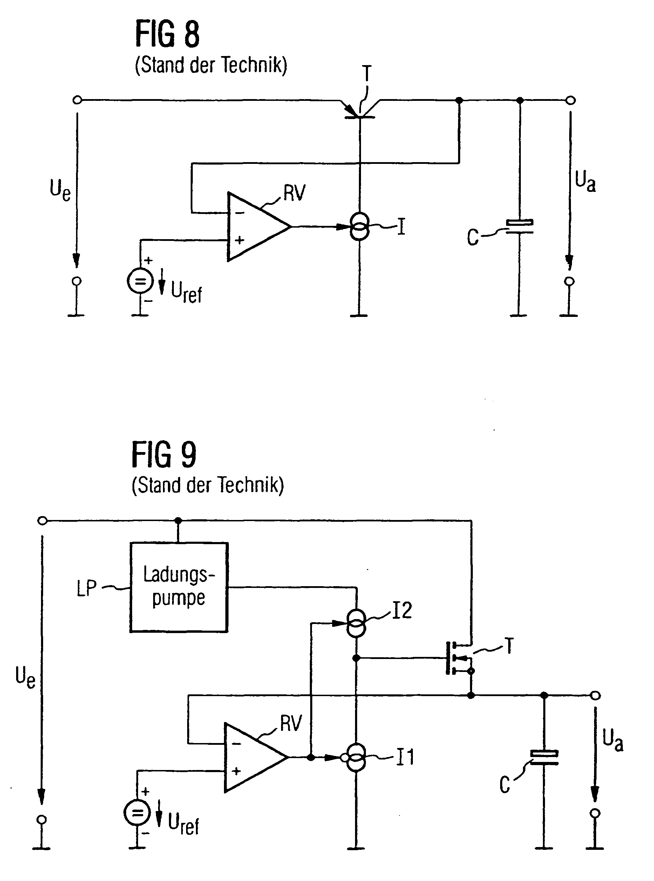

Fig. 8 zeigt ein vereinfachtes Blockschaltbild einer bekannten Spannungsreglerschaltung, wobei gemäß diesem Beispiel als Stellglied ein pnp-Stelltransistor T zum Einsatz kommt. Mit Hilfe dieses Stelltransistors T wird eine Eingangsspannung $U_e$ in eine möglichst störungsfreie und stabilisierte Ausgangsspannung $U_a$ umgewandelt. Ein Eingangsanschluß eines Regelungsverstärkers RV überwacht die Ausgangsspannung $U_a$ und erzeugt aufgrund eines Vergleichs mit einer an dem anderen Eingangsanschluß anliegenden Referenzspannung $U_{ref}$ ein Stellsignal für eine steuerbare Stromquelle I, die einen Steuerstrom für den Stelltransistor T erzeugt. Durch das Zusammenwirken des Stelltransistors T mit dem Regelungsverstärker RV und der steuerbaren Stromquelle I kann auf diese Weise die gewünschte stabilisierte Ausgangsspannung $U_a$ erzeugt werden. Die Verwendung des in Fig. 8 gezeigten pnp-Stelltransistors T ist aufgrund der dabei zum Einsatz kommenden kostengünstigen Bipolartechnologie vorteilhaft, welche leistungsfähige pnp-Transistoren ermöglicht.

Die Tendenz zukünftiger elektronischer Geräte geht jedoch in Richtung "Systems on Silicon", d. h. ein Chip soll möglichst viele verschiedene Funktionen beinhalten können, damit ein Gerät aus möglichst wenigen Chips aufgebaut werden kann. Daher wird angestrebt, Spannungsregler auf sogenannten "Smart Power Chips" zu integrieren, welche gemäß einer Mischtechnologie hergestellt werden, die einerseits für DMOS-Leistungstransistoren und CMOS-Logik optimiert sind und zudem bipolare Bauelemente aufweisen. Ein weiteres Ziel ist es, die Außenbeschaltung der Spannungsregler möglichst gering zu halten.

Der in Fig. 8 gezeigte Spannungsregler mit dem pnp-Bipolartransistor T erfordert jedoch stets einen eigenen Chip. Zudem ist aufgrund der niedrigen Transitfrequenz integrierter lateraler pnp-Transistoren der ebenfalls in Fig. 8 gezeigte relativ große Ausgangskondensator C erforderlich, der über einen möglichst weiten Temperaturbereich einen niedrigen Serienwiderstand aufweist. Der Kondensator C kann beispielsweise durch einen Tantal-Elektrolyt-Kondensator mit einer Kapazität zwischen 10 und 22 $\mu$F gebildet sein.

Für Smart-Power-Technologien wurden daher bisher Spannungsregler verwendet, die einen DMOS-Stelltransistor mit einer dazugehörigen Ladungspumpe zur Erzeugung der benötigten hohen Gatespannung aufweisen. Fig. 9 zeigt ein Blockschaltbild einer bekannten DMOS-Spannungsreglerschaltung, wobei diejenigen Bauteile, die denen in Fig. 8 gezeigten Bauteilen entsprechen, mit denselben Bezugszeichen versehen sind. Aus Fig. 9 ist ersichtlich, daß als Stelltransistor T ein n-Kanal-DMOS-Feldeffekttransistor verwendet wird, dessen Gateanschluß durch steuerbare Stromquellen I1 und I2 angesteuert wird. Die beiden Stromquellen I1 und I2 werden ihrerseits von dem Ausgangssignal des Regelungsverstärkers RV angesteuert, wobei die Stromquelle I1 durch das Ausgangssignal des Regelungsverstärkers RV invertiert zu der Stromquelle I2 eingestellt wird. Des weiteren ist in Fig. 9 eine Ladungspumpe LP dargestellt, die dafür sorgt, daß an dem Gateanschluß des Stelltransistors T eine erhöhte Gatespannung anliegt.

Der in Fig. 9 gezeigte Spannungsregler weist jedoch den Nachteil auf, daß er aufgrund der Ruhestromaufnahme der Ladungspumpe LP eine sehr hohe Stromaufnahme (z. B. einige mA) besitzt, so daß beispielsweise bei Kraftfahrzeuganwendungen der Spannungsregler auch bei abgestelltem Fahrzeug abgeschaltet werden muß. Die Verwendung von n-Kanal-DMOS-Transistoren ist jedoch in Spannungsreglern deshalb vorteilhaft, da sich allgemein pnp- oder p-Kanal-MOS-Transistoren nicht für Smart-Power-Chips eignen, da sie bei Anwendung der Smart-Power-Technologie nur mit geringen Stromdichten betrieben werden können.

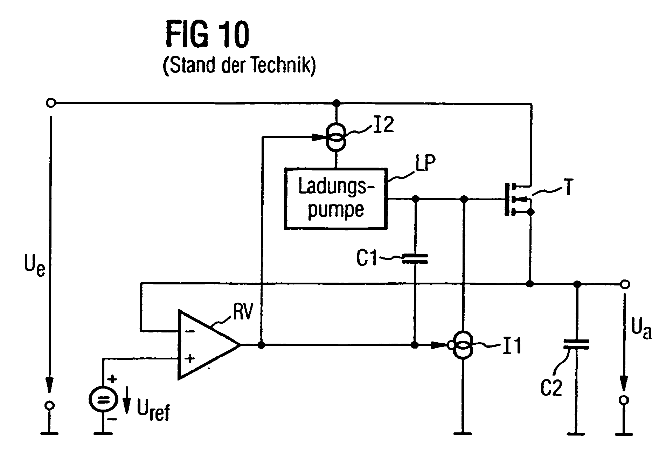

Fig. 10 zeigt ein Blockschaltbild einer weiteren bekannten Spannungsreglerschaltung, wie sie beispielsweise in der US-Patentschrift Nr. 5,654,628 offenbart ist. Dieser Spannungsregler umfaßt einen Eingangsanschluß zum Empfangen einer (ungeregelten) Eingangsspannung $U_e$ und einen Ausgangsanschluß zum Bereitstellen einer (geregelten) Ausgangsspannung $U_a$, wobei ein n-Kanal-DMOS-Feldeffekttransistor T als Stellglied zwischen den Eingangs- und Ausgangsanschluß geschaltet ist. Des weiteren wird wiederum ein Regelverstärker RV verwendet, der die geregelte Ausgangsspannung $U_a$ an einem seiner Eingänge empfängt und ein entsprechendes Ausgangssignal für steuerbare Stromquellen I1 bzw. I2 erzeugt. Ein Kondensator C1 ist zwischen den Ausgangsanschluß des Regelverstärkers RV und den Steueranschluß des Transistors T geschaltet. Die Stromquelle I2 entspricht der internen Stromquelle der Ladungspumpe LP, welche infolge einer entsprechenden Ansteuerung durch den Regelverstärker RV eine erhöhte Ausgangsspannung für den Transistor T erzeugt, um die Gatespannung des Transistors T zu stützen. Die Stromquelle 11 dient zum Entladen des Kondensators C1, wobei im Falle eines Abfalls der Ausgangsspannung $U_a$ ein erhöhtes Ausgangssignal des Regelverstärkers RV dafür sorgt, daß der Strom der Stromquelle I1 infolge der invertierten Ansteuerung durch den Regelverstärker RV verringert wird. Das Ausgangssignal des Regelverstärkers RV wird des weiteren über den Kondensator C1 dem Transistor T zugeführt, so daß das Signal $U_a$ am Ausgangsanschluß wegen des relativ konstanten Spannungsabfalls entlang des Gate-Source-Pfads des Transistors T erhöht wird. Mit Hilfe des Kondensators C1 können schnelle ausgangsseitige Laständerungen des Spannungsreglers ausgeglichen werden, und der Spannungsregler kann auch mit einer kleinen Ausgangskapazität C2 (z. B. mit einem 100 nF-Keramikkondensator) stabil arbeiten.

Wie bereits zuvor anhand Fig. 9 und 10 erläutert worden ist, werden häufig Ladungspumpen zur Ansteuerung von Leistungs-MOS-Transistoren eingesetzt. Damit die dabei verwendete Ladungspumpenschaltung mit möglichst kleinen integrierten Kondensatoren auskommt, muß sie jedoch mit einer möglichst hohen Frequenz betrieben werden, wodurch jedoch das Problem der elektromagnetischen Abstrahlung entsteht. Um diesem Problem entgegenzuwirken, wurde beispielsweise in der EP 0633662 A1 eine Ladungspumpe vorgeschlagen, welche eine Schaltungsanordnung umfaßt, die mehrere ineinander verschachtelte Signale erzeugt, wobei jeweils zwei dieser Signale genau komplementär zueinander verlaufende und abgeflachte Flanken aufweisen, die zu einer geringeren elektromagnetischen Abstrahlung der Ladungspumpe führen. Die in der EP 0 633 662 A1 beschriebene Schaltungsanordnung entspricht im wesentlichen einem Ringoszillator mit zwei Reihenschaltungen aus mehreren Treiberstufen, wobei der Ausgang der letzten Treiberstufe der einen Reihenschaltung mit dem Eingang der ersten Treiberstufe der anderen Reihenschaltung verbunden ist. Die Ausgänge der Treiberstufen der einzelnen Reihenschaltungen sind über Haltestufen miteinander verbunden, die beispielsweise durch jeweils zwei entgegengesetzt zueinander verschaltete Inverter gebildet sind. An den Ausgängen der einzelnen Treiberstufen können invertierte Ausgangssignale abgegriffen werden. Wie bereits erläutert worden ist, ist mit Hilfe dieser Schaltungsanordnung eine Unterdrückung von Störaussendungen möglich, was bei Spannungsreglern von erheblicher Bedeutung ist. Die in der EP 0 633 662 A1 beschriebene Ladungspumpe erzeugt jedoch rechteckförmige Ausgangssignale, wodurch grundsätzlich - wenn auch in geschwächter Form - weiterhin Störungen ausgesendet werden.

In DE 4439787 A1 wird es ein Verfahren (und eine Schaltungsanordnung) zum Verschieben einer Spannung angegeben, durch das es möglich wird, daß eine außerhalb eines Arbeitsbereichs eines elektrischen Bauelements liegende Eingangsspannung so verschoben wird, daß sie in dam Arbeitsbereich des Bauelements liegt, wobei der Energieverbrauch für das Verschieben der Spannung minimiert ist. In einem Ausführungsbeispiel der Erfindung wird der Einsatz der erfindungsgemäßen Vorrichtung in einem "switched capacitor" A/D-Wandler aufgezeigt Durch the spezielle Potentialverschiebungstechnik wird die interne Masse des A/D-Wandlers geeignet verschoben, so daß zum Beispiel bei einem Einsatz des A/D-Wandlers in einem integrierten Schaltkreis zur Batterieüberwachung und Ladung, Ströme sowie beim Ladevorgang als auch beim Entladevorgang detektiert werden können.

Der vorliegenden Erfindung liegt unter Berücksichtigung des zuvor erläuterten Stands der Technik somit die Aufgabe zugrunde, eine verbesserte Schaltungsanordnung für eine Ladungspumpe zu schaffen, die insbesondere eine verringerte Stromaufnahme ermöglicht und für den Einsatz in Spannungsreglern auf Smart-Power-ICs gemäß der DMOS-Technologie geeignet ist. Des weiteren soll die Schaltungsanordnung eine verbesserte elektromagnetische Verträglichkeit (EMV) aufweisen.

Darüber hinaus liegt der vorliegenden Erfindung die Aufgabe zugrunde, einen verbesserten Spannungsregler zu schaffen, der bei vorgegebener maximaler Ausgangsspannung eine verringerte Stromaufnahme aufweist.

Die vorstehenden Aufgaben werden gemäß der vorliegenden Erfindung hinsichtlich der Schaltungsanordnung durch eine Schaltungsanordnung für eine Ladungspumpe mit den Merkmalen des Anspruches 1 und hinsichtlich des Spannungsreglers durch eine Spannungsreglerschaltung mit den Merkmalen des Anspruches 19 gelöst. Die Unteransprüche beschreiben jeweils bevorzugte und vorteilhafte Ausführungsformen der vorliegenden Erfindung, die ihrerseits zu einem möglichst einfachen Aufbau der erfindungsgemäßen Schaltungsanordnung bzw. Spannungsreglerschaltung sowie einer möglichst geringen Stromaufnahme und bestmöglicher Stabilität beitragen.

Die Schaltungsanordnung weist gemäß der vorliegenden Erfindung zwei Reihenschaltungen aus mehreren Integratoren auf, die jeweils über entsprechende Rückkopplungszweige miteinander gekoppelt sind, so daß an den Ausgängen der einzelnen Integratoren entsprechende zueinander phasenversetzte sinusförmige Ausgangssignale erzeugt werden können, was im Gegensatz zu den aus der EP 0 633 662 A1 bekannten phasenverschobenen Rechteckimpulsen hinsichtlich der elektromagnetischen Verträglichkeit (EMV) vorteilhaft ist. Vorteilhafterweise umfaßt die Schaltungsanordnung vier Integratoren, die somit vier jeweils um 90° gegeneinander phasenversetzte näherungsweise sinusförmige Ausgangssignale erzeugen.

Vorteilhafterweise sind die Integratoren in Form von gesteuerten Invertern mit mehreren Eingängen realisiert, so daß bestimmte Eigenschaften dieser Integratoren durch Anlegen entsprechender Steuersignale verändert werden können. Dabei liegt diesem Erfindungsaspekt insbesondere die Erkenntnis zugrunde, daß die Stromaufnahme der Schaltungsanordnung bzw. des gesamten Spannungsreglers deutlich reduziert werden kann, wenn die (Schaltungs-)Frequenz der Ladungspumpe soweit vermindert wird, daß die Stromabgabe der Ladungspumpe auf einen geforderten Wert absinkt. Durch Ansteuerung der steuerbaren Integratoren der Schaltungsanordnung können somit beispielsweise vier jeweils um 90° gegeneinander phasenversetzte näherungsweise sinusförmige Ausgangssignale erzeugt werden, deren Frequenz mit Hilfe externer Steuersignale verändert werden kann.

Besonders vorteilhaft ist die Verwendung der erfindungsgemä-βen Schaltungsanordnung in einem Spannungsregler der eingangs beschriebenen Art, wenn der dabei verwendete Regelverstärker als sogenannter Class-B-Verstärker mit geringem Ruhestrom ausgeführt ist und bei einer genügend hohen Eingangsspannung ein Steuersignal für die Ladungspumpe des Spannungsreglers erzeugt, welches der Ausgangsfrequenz Null entspricht. Dabei wird eine zusätzliche Stromquelle eingesetzt, die in diesem Fall die für den DMOS-Stelltransistor nötige Gateladung aufrechterhält.

Die im Zusammenhang mit dem erfindungsgemäßen Spannungsregler vorgeschlagene frequenzvariable Ladungspumpe läßt sich insbesondere für sogenannte High-Side-Schalter einsetzen, bei denen ein schnelles Einschalten und bei eingeschaltetem Schalter eine niedrige Störaussendung mit geringer Stromaufnahme gefordert ist.

Die vorliegende Erfindung wird nachfolgend anhand bevorzugter Ausführungsbeispiele unter Bezugnahme auf die Zeichnungen näher erläutert.

Fig. 1 zeigt ein Blockschaltbild eines bevorzugten Ausführungsbeispiels eines Spannungsreglers gemäß der vorliegenden Erfindung,

Fig. 2a -.2c zeigen Darstellungen zur Erläuterung der Tatsache, warum durch Verringerung der Frequenz der Ladungspumpe die Stromaufnahme reduziert werden kann,

Fig. 3 zeigt ein Schaltbild eines bevorzugten Ausführungsbeispiels einer Schaltungsanordnung für eine Ladungspumpe gemäß der vorliegenden Erfindung,

Fig. 4 zeigt ein detailliertes Schaltbild eines in Fig. 3 dargestellten Integrators,

Fig. 5 zeigt ein detailliertes Schaltbild eines in Fig. 3 gezeigten Treibers,

Fig. 6 zeigt ein detailliertes Schaltbild einer Schaltung zur Erzeugung von Steuersignalen für die in den Fig. 3-5 gezeigten Integratoren und Treiber,

Fig. 7 zeigt ein Schaltbild eines Spannungsreglers gemäß einem weiteren bevorzugten Ausführungsbeispiel der vorliegenden Erfindung, und

Fig. 8 - 10 zeigen Schaltbilder bekannter Spannungsregler.

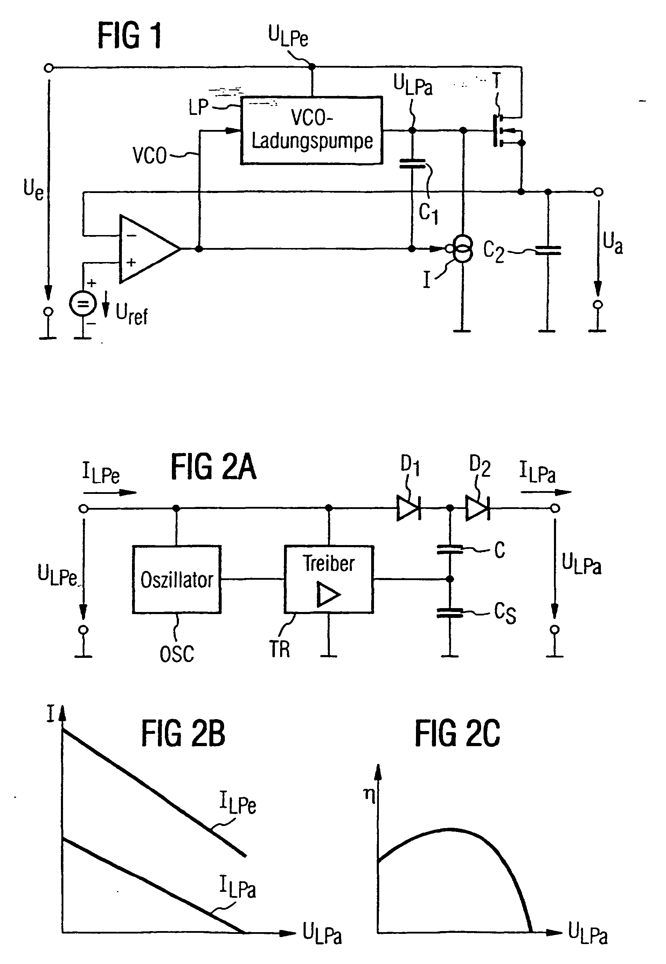

Das in Fig. 1 gezeigte bevorzugte Ausführungsbeispiel eines erfindungsgemäßen Spannungsreglers entspricht im wesentlichen dem in Fig. 10 gezeigten Spannungsregler. Der in Fig. 1 gezeigte Spannungsregler umfaßt einen Eingangsanschluß zum Empfangen einer ungeregelten Eingangsspannung $U_e$ sowie einen Ausgangsanschluß zum Bereitstellen einer (geregelten) Ausgangsspannung $U_a$. Ein Stelltransistor T ist mit seinem Hauptstrompfad bzw. seiner Laststrecke zwischen den Eingangs- und den Ausgangsanschluß geschaltet. Gemäß Fig. 1 ist der Transistor T insbesondere in Form eines n-Kanal-DMOS-Feldeffekttransistors ausgebildet. Ein Regelverstärker RV überwacht an seinem invertierten Eingang die am Ausgangsanschluß bereitgestellte Ausgangsspannung $U_a$ und vergleicht diese mit einer an seinem weiteren Eingang anliegenden Referenzspannung $U_{ref}$. Ein Kondensator T1 ist zwischen den Ausgang des Regelverstärkers RV und den Steuer- bzw. Gateanschluß des Stelltransistors T geschaltet. Eine Stromquelle I dient zum Entladen des Kondensators C1 und wird invertiert von dem Ausgangssignal des Regelverstärkers RV gesteuert. Des weiteren ist eine Ladungspumpe LP vorgesehen, welche eine erhöhte Spannung für den Steueranschluß des Stelltransistors T erzeugt. Am Ausgang des Spannungsreglers ist ein Ausgangskondensator C2 vorgesehen, über den die Ausgangsspannung $U_a$ ausgegeben wird.

Im Gegensatz zu dem in Fig. 10 gezeigten Spannungsregler wird jedoch gemäß dem in Fig. 1 gezeigten Ausführungsbeispiel die Frequenz der Ladungspumpe LP durch das Ausgangssignal des Regelverstärkers RV eingestellt, d. h. bei der Ladungspumpe LP handelt es sich um eine spannungsgesteuerte frequenzvariable Ladungspumpe (VCO-Ladungspumpe), wobei die Frequenz der Ladungspumpe LP zur Verringerung der Stromaufnahme an die jeweiligen Bedürfnisse angepaßt wird.

Dies soll nachfolgend näher anhand der in Fig. 2a - 2c dargestellten Diagramme erläutert werden.

Fig: 2a zeigt ein stark vereinfachtes Blockschaltbild einer verdoppelnden Ladungspumpe, die in Übereinstimmung mit Fig. 1 als Eingangsspannung eine Spannung $U_{LPe}$ empfängt und eine Ausgangsspannung $U_{LPa}$ ausgibt. Gemäß Fig. 2a kann die Ladungspumpe als Kombination eines Ringoszillators OSC mit einem nachfolgenden Treiber TR dargestellt werden, wobei die Ausgangssignale des Treibers TR über ein Dioden-Kondensator-Netzwerk mit Dioden D1 und D2 sowie einem Pumpkondensator C ausgegeben werden. Des weiteren ist in Fig. 2a ein Kondensator $C_s$ dargestellt, welcher der unvermeidlichen, durch die monolithische Integration bedingten parasitären Substratkapazität der in der Ladungspumpe verwendeten Pumpkondensatoren entspricht. Zwischen dem von der verdoppelnden Ladungspumpe aufgenommenen Strom $I_{Lpe}$ und dem abgegebenen Strom $I_{Lpa}$ bestehen folgende Zusammenhänge:

$$I_{LPe}=C_s \cdot f \cdot U_{LPe}+2 \cdot C \cdot f \cdot (2 \cdot U_{LPe}-U_{LPa}-2 \cdot U_D)$$

$$I_{LPa}=C \cdot f \cdot (2 \cdot U_{LPe}-U_{LPa}-2 \cdot U_D)$$

In Fig. 2b ist der Verlauf des aufgenommenen Stroms $I_{Lpe}$ und des abgegebenen Stroms $I_{LPa}$ in Abhängigkeit von der Ausgangsspannung $U_{LPa}$ der verdoppelnden Ladungspumpe dargestellt. Aus den obigen Formeln ist ersichtlich, daß der für die periodische Auf- und Entladung der parasitären Kapazitäten notwendige Ladestrom einen Hauptanteil der Leerstromaufnahme einer Ladungspumpe darstellt. Weitere Anteile der Ruhestromaufnahme der Ladungspumpe entstehen zudem durch Querströme der Treiberstufen TR und durch die Stromaufnahme des Oszillators OSC.

Ergänzend ist in Fig. 2c der Wirkungsgrad in Abhängigkeit von der Ausgangsspannung $U_{LPa}$ dargestellt. Dabei ist aus Fig. 2c ersichtlich, daß der Wirkungsgrad n bei Leerlauf der Ladungspumpe gleich Null ist und ein Maximum besitzt, welches bei einer Eingangsspannung $U_{Lpe}$ =5V, einer Nutzkapazität C=5 pF und einer Substratkapazität $C_s$=1,2 pF bei einer Ausgangsspannung $U_{LPa}$ = 7V liegt. Wird von der Ladungspumpe nur eine geringe Leistungsabgabe gefordert, was beispielsweise bei eingeschwungenem Regelkreis und bei geringer Belastung des Spannungsreglers der Fall ist, sollte die Ladungspumpe aus diesem Grunde nicht leerlaufen, was zunächst naheliegend wäre, oder die Eingangsspannung $U_{LPe}$ der Ladungspumpe verringert werden, was gemäß der US 5,654,628 (vergl. Fig. 10) vorgeschlagen wird.

Vielmehr ist es vorteilhaft, statt dessen die Frequenz der Ladungspumpe soweit zu verringern, daß die Stromabgabe der Ladungspumpe auf den gewünschten bzw. geforderten Wert absinkt, um auf diese Weise eine sehr geringe Stromaufnahme zu erzielen. Daher ist gemäß Fig. 1 die Ladungspumpe LP derart ausgestaltet, daß ihre Frequenz abhängig von dem Ausgangssignal des Regelverstärkers RV variabel ist. Dabei kann die Ladungspumpe LP als mehrphasige Ladungspumpe ausgestaltet sein, die mehrere gegeneinander phasenversetzte sinusförmige Ausgangssignale erzeugt, wobei die Frequenz dieser Ausgangssignale mit Hilfe des Steuersignals VCO des Regelverstärkers RV veränderbar ist. Die mit der Ladungspumpe LP höchste erzeugbare Frequenz sollte vorteilhafterweise genauso hoch sein wie die mit Hilfe eines auf Inverterlaufzeiten basierenden Oszillators erzeugbare Frequenz (vergl. die eingangs beschriebene EP 0 633 662 A1).

Aus IEEE Journal of Solid-State Circuits, VOL. 32, NO.6, June 1997, "Efficiency Improvement in Charge Pump Circuits" ist im Prinzip bereits die Verwendung von frequenzvariablen Ladungspumpen bekannt. Insbesondere ist in dieser Druckschrift das Problem beschrieben, daß Ladungspumpen Transistorschaltungen verwenden, welche mit einer bestimmten Schaltfrequenz betrieben werden, wobei gemäß dem bekannten Stand der Technik die Schaltfrequenz derart festgelegt wird, daß auch bei einer maximalen Ausgangslast der Ladungspumpe ein ausreichend hoher Ausgangssignalpegel erzielt werden kann, wobei dies jedoch zur Folge hat, daß bei einer geringen Belastung der Ladungspumpe unnötigerweise ein beträchtlicher Versorgungsstrom benötigt wird, so daß insbesondere bei Systemen, die größtenteils ohne Last betrieben werden, ein erheblicher Energieverbrauch die Folge ist. Demzufolge wurde in dieser Druckschrift vorgeschlagen, die Schaltfrequenz der Ladungspumpe abhängig von der Last zu variieren, so daß bei einer geringeren Last die Schaltfrequenz der Ladungspumpe reduziert wird, was eine verbesserte Leistungsfähigkeit, einen geringeren Stromverbrauch und geringere Durchbruchspannungsanfordernisse der Ladungspumpe zur Folge hat. In dieser Druckschrift wird jedoch nicht der Einsatz der Ladungspumpe in Spannungsreglerschaltungen beschrieben, so daß diese Druckschrift auch keinen Vorschlag macht, wie die Ansteuerung der Ladungspumpe in einer Spannungsreglerschaltung erfolgen könnte, um die Frequenz der Ladungspumpe zu variieren.

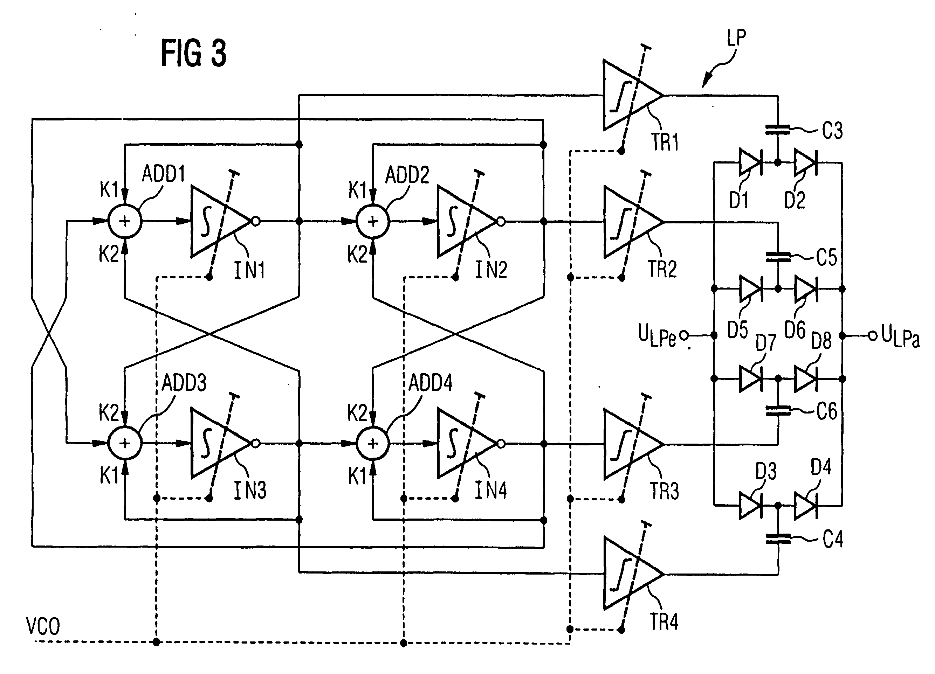

Dagegen zeigt Fig. 3 ein Schaltbild eines bevorzugten Ausführungsbeispiels der in Fig. 1 dargestellten frequenzvariablen Ladungspumpe LP, die zudem die zuvor gekannten Voraussetzungen erfüllt. Die in Fig. 3 gezeigte Schaltung umfaßt zwei Reihenschaltungen, die mehrere gemeinsam angesteuerte Integratoren bzw. Integrierer IN1 -IN4 aufweisen, wobei die einzelnen Integratoren IN1-IN4 über Rückkopplungszweige miteinander verschaltet sind. Insbesondere ist in Fig. 3 ein Beispiel einer verdoppelnden mehrphasigen Ladungspumpe dargestellt, wobei jede Reihenschaltung zwei gesteuerte Integratoren IN1, IN2 bzw. IN3, IN4 aufweist. Der Ausgang des letzten Integrators einer jeden Reihenschaltung ist an den Eingang des ersten Integrators der anderen Reihenschaltung geführt. Des weiteren ist der Ausgang eines jeden Integrators über einen ersten Rückkopplungszweig mit dem Verstärkungsfaktor K1 an seinen Eingang und über einen zweiten Rückkopplungszweig mit dem Verstärkungsfaktor K2 an den Eingang des entsprechenden Integrators der anderen Reihenschaltung geführt. Das Eingangssignal eines jeden Integrators IN1 - IN4 entspricht dem Ausgangssignal eines Addierers ADD1 - ADD4. Somit entspricht das Eingangssignal der Integratoren IN1 bzw. IN3 dem Summensignal aus dem Ausgangssignal des Integrators IN4 bzw. des Integrators IN2, dem mit dem Verstärkungsfaktor K1 multiplizierten Ausgangssignal des Integrators IN1 bzw. IN3 und dem mit dem Verstärkungsfaktor K2 multiplizierten Ausgangssignal des Integrators IN3 bzw. IN1. Das Eingangssignal der Integratoren IN2 bzw. IN4 entspricht hingegen dem Summensignal aus dem Ausgangssignal des Integrators IN1 bzw. IN3, dem mit dem Verstärkungsfaktor K1 multiplizierten Ausgangssignal des Integrators IN2 bzw. IN4 und dem mit dem Verstärkungsfaktor K2 multiplizierten Ausgangssignal des Integrators IN4 bzw. IN2.

Die Verstärkungsfaktoren der Rückkopplungszweige sind derart eingestellt, daß gilt: K2>K1, K2-K1<1 (Schwingbedingung) und K1+K2>1 (Stabilitätsbedingung).

Gemäß Fig. 3 werden die einzelnen Integratoren IN1 - IN4 abhängig von dem Steuersignal VCO des in Fig. 1 gezeigten Regelverstärkers RV angesteuert. An den Ausgängen der einzelnen Integratoren IN1 - IN4 werden zueinander jeweils um 90° phasenversetzte näherungsweise sinusförmige Ausgangssignale abgegriffen, die über Treiberstufen TR1 - TR4 geführt werden, wobei auch diese Treiberstufen TR1 - TR4 vorzugsweise abhängig von dem Steuersignal VCO eingestellt werden, um beispielsweise die Flankensteilheit der Treiber TR1 - TR4 zu verändern. Die Ausgangssignale werden über ein Dioden-Kondensator-Netzwerk mit Kondensatoren C3 - C6 und Dioden D1 - D8 mit der an der Ladungspumpe anliegenden Eingangsspannung $U_{Lpe}$ kombiniert, um schließlich die erhöhte Ausgangsspannung $U_{Lpa}$ zu erhalten.

Obwohl gemäß Fig. 3 die Schaltungsanordnung mit steuerbaren Integratoren IN1 - IN4 und steuerbaren Treibern TR1 - TR4 ausgestaltet ist, kann die in Fig. 3 gezeigte Schaltungsanordnung selbstverständlich auch ohne Steuerbarkeit der Integratoren und/oder Treiber ausgestaltet sein, da auch in diesem Fall an den Ausgängen der Integratoren zueinander phasenversetzte sinusförmige Signale abgegriffen werden können, was hinsichtlich der elektromagnetischen Verträglichkeit (EMV) deutlich vorteilhaft im Vergleich zu den aus der EP o 633 662 A1 bekannten phasenverschobenen Rechteckimpulsen ist.

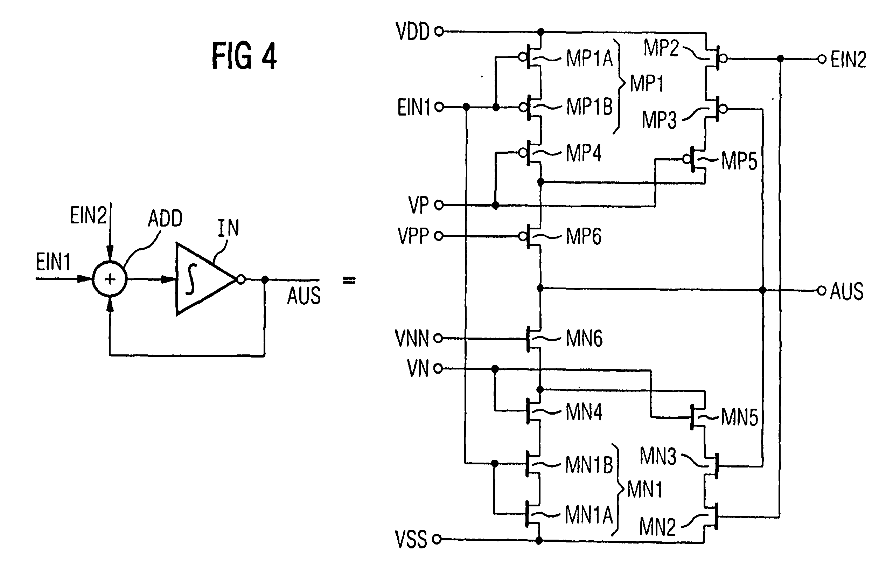

Die in Fig. 3 gezeigten gesteuerten Integratoren IN1 - IN4 können als gesteuerte Inverter mit mehreren Eingängen, insbesondere mehreren Steuereingängen, realisiert werden. Dabei bildet die steuerbare Übertragungskennlinie des Inverters zusammen mit der Verdrahtungskapazität jeweils einen steuerbaren Integrator. Fig. 4 zeigt eine mögliche Schaltung für einen steuerbaren Integrator.

Gemäß Fig. 4 umfaßt die Schaltung einen positiven Versorgungsspannungsanschluß VDD, einen negativen Versorgungsspan nungsanschluß VSS, einen ersten Eingangsanschluß EIN1 für das erste Eingangssignal des entsprechenden Addierers, einen zweiten Eingangsanschluß EIN1 für das zweite Eingangssignal des entsprechenden Addierers sowie vier Steueranschlüsse VP, VPP, VNN und VN, an die entsprechende Steuersignale anzulegen sind. Der in Fig. 4 gezeigte Integrator bzw. Inverter ist durch eine Kombinationsschaltung von p-Kanal- und n-Kanal-Sperrschicht-Feldeffekttransistoren aufgebaut. Dabei bilden die Transistoren MN1 - MN3 und MP1 - MP3 von den Eingangssignalen abhängige gesteuerte Widerstände. Diese Widerstände können wahlweise parallel oder in Serie geschaltet werden, wobei durch Parallelschaltung die maximal mögliche Frequenz des Oszillators der Ladungspumpe erhöht und durch Serienschaltung die Stromaufnahme des Oszillators vermindert werden kann. Gemäß dem in Fig. 4 gezeigten Ausführungsbeispiel wurde eine Kombination aus Parallel- und Serienschaltung gewählt, die sich als günstiger Kompromiß erwiesen hat, wobei jeweils zwei Transistoren MN2, MN3 bzw. MP2, MP3 in Serie geschaltet sind, während dazu parallel ein weiterer Transistor MN1 bzw. MP1 angeordnet ist. Aus Gründen der Fertigbarkeit sind jedoch gemäß Fig. 4 auch die nicht in Serie geschalteten Transistoren MN1 und MP1 ebenfalls in Form einer Serienschaltung aus jeweils zwei Transistoren MN1A und MN1B bzw. MP1A und MP1B ausgeführt. Die notwendigen Verstärkungsfaktoren der einzelnen Eingänge können durch unterschiedliche Kanallängen und Kanalweiten der Transistoren eingestellt werden. Des weiteren umfaßt die in Fig. 4 gezeigte Schaltung Transistoren MN4, MN5 und MN5, MP5, welche als Stromquellentransistoren dienen und abhängig von den Steuersignalen VP und VN den Gesamt-Stromfluß über den Inverter und damit die Übertragungskennlinie des Inverters steuern. Zudem können optional Kaskodetransistoren MP6 und MN6 eingefügt sein, die über die Steuersignale VPP bzw. VNN gesteuert werden und zur Erweiterung des Frequenzbereichs dienen. Insgesamt ist aus Fig. 4 ersichtlich, daß die Inverterschaltung aus im wesentlichen spiegelsymmetrischen p-Kanal- und n-Kanal-MOS-Transistorbereichen besteht.

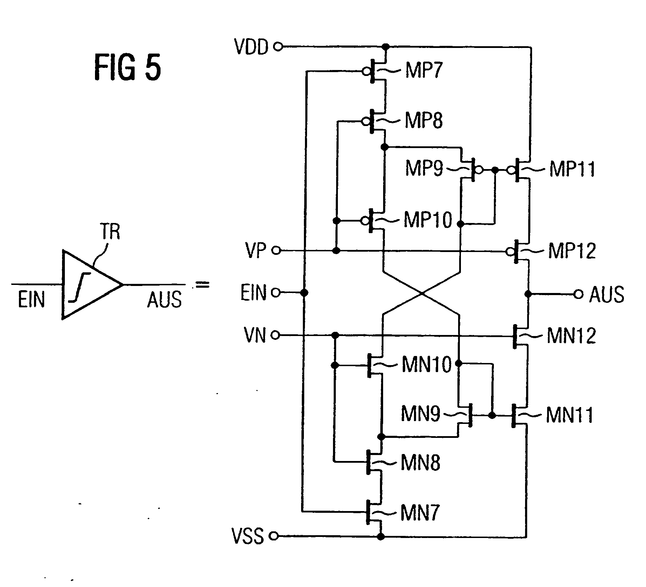

Wie bereits anhand Fig. 3 erläutert worden ist, können auch die einzelnen Treiber TR1 - TR4 abhängig von dem Ausgangssignal des Regelverstärkers RV eingestellt werden, wobei es für eine minimale Störabstrahlung insbesondere zweckmäßig ist, die Flankensteilheiten dieser Ausgangstreiber proportional zur Oszillatorfrequenz der Ladungspumpe einzustellen. Fig. 5 zeigt ein Beispiel einer querstromfreien Treiberschaltung mit den genannten Merkmalen, wobei die Flankensteilheit insbesondere abhängig von den Steuersignalen VN, VP (vergl. Fig. 4) einstellbar ist. Auch die in Fig. 5 gezeigte Treiberschaltung umfaßt wiederum die Kombination von p-Kanal- und n-Kanal-MOS-Sperrschichttransistoren MP7 - MP12 bzw. MN7 - MN12, wobei der Bereich mit den p-Kanal-Transistoren im wesentlichen spiegelsymmetrisch zu dem Bereich mit den n-Kanal-Transistoren aufgebaut ist.

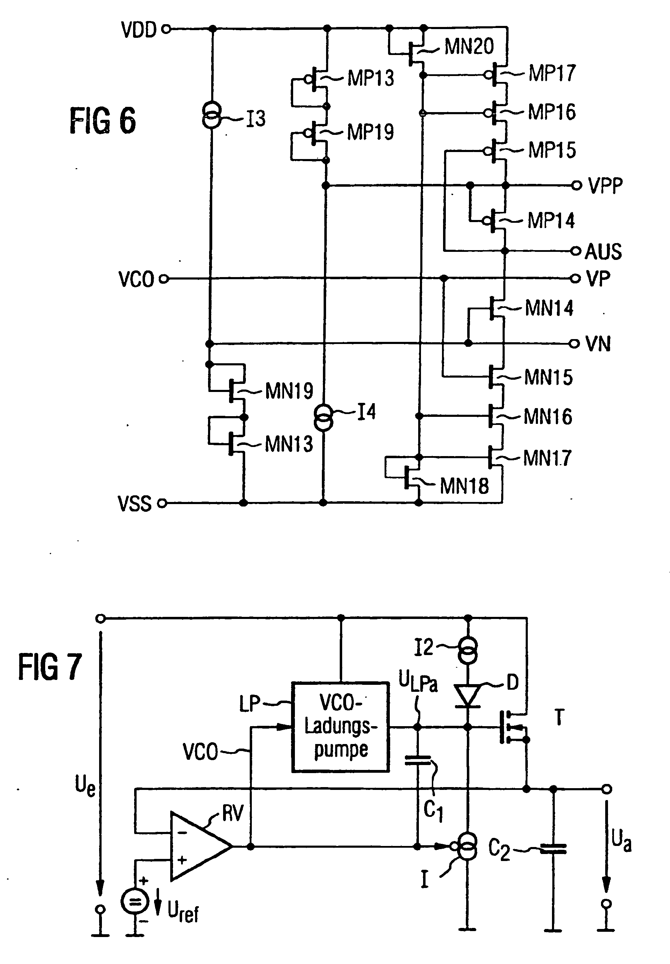

Der in Fig. 4 gezeigte Integrator sowie der in Fig. 5 gezeigte Treiber werden abhängig von Steuersignalen VP, VPP, VNN und VN angesteuert, welche aus dem Ausgangssignal VCO des Regelverstärkers RV (vergl. Fig. 1) abgeleitet werden. Demzufolge muß die in Fig. 3 gezeigte Ladungspumpe eine Steuerschaltung aufweisen, welche abhängig von dem Ausgangssignal VCO des Regelverstärkers RV die entsprechenden Steuersignale VP, VPP, VNN bzw. VN erzeugt. Eine entsprechende Steuerschaltung ist beispielhaft in Fig. 6 dargestellt, die wiederum eine Kombination von p-Kanal-Sperrschicht-Feldeffekttransistoren MP13 - MP1 und n-Kanal-Sperrschicht-Feldeffekttransistoren MN13 - MN20 aufweist. Des weiteren umfaßt die Steuerschaltung interne Stromquellen I3 und I4. Die nähere Verschaltung kann Fig. 6 entnommen werden.

Da gemäß Fig. 3 die einzelnen Integratoren IN1 - IN4 und Treiber TR1 - TR4 gemeinsam abhängig von dem Steuersignal VCO des Regelverstärkers RV eingestellt werden sollen, genügt es, eine der in Fig. 6 gezeigten Schaltung entsprechende zentrale Steuerschaltung in der Ladungspumpe vorzusehen, die abhängig von dem Steuersignal VCO die Steuersignale VPP, VP, VN und VNN erzeugt. Alternativ ist jedoch auch denkbar, daß die in Fig. 6 gezeigte Schaltung in jede der in Fig. 4 und 5 gezeigten Schaltungen, d. h. in jede Integrator- und Treiberschaltung, integriert wird.

Fig. 7 zeigt schließlich ein weiteres bevorzugtes Ausführungsbeispiel des erfindungsgemäßen Spannungsreglers, wobei insbesondere die in Fig. 3 gezeigte frequenzvariable Ladungspumpe LP (VCO-Ladungspumpe) eingesetzt werden kann, deren Frequenz wiederum abhängig von dem Ausgangssignal VCO des Regelverstärkers RV eingestellt wird, um somit die Frequenz der Ladungspumpe LP an die augenblickliche Last bzw. die erforderliche Stromabgabe anzupassen und somit die Stromaufnahme der Ladungspumpe zu minimieren. Des weiteren ist gemäß Fig. 7 der Regelverstärker RV als sogenannter Class-B-Verstärker mit geringem Ruhestrom ausgeführt und erzeugt bei einer genügend hohen Eingangsspannung (z. B. größer als 8V) ein derartiges Steuersignal VCO für die Ladungspumpe LP, welches der Frequenz 0 entspricht. Um auch in diesem Fall die für den Stelltransistor T erforderliche Gateladung aufrechtzuerhalten, ist gemäß Fig. 7 eine weitere Stromquelle I2 vorgesehen, welche über eine Diode D mit dem Gateanschluß des Transistors T gekoppelt ist. Mit Hilfe der in Fig. 7 gezeigten Spannungsreglerschaltung kann die Stromaufnahme des Spannungsreglers weiter verringert werden.

**Patentansprüche**

1. Schaltungsanordnung für eine Ladungspumpe, mit
   einer ersten Reihenschaltung von n Integratoren (IN1, IN2) und einer zweiten Reihenschaltung von n weiteren Integratoren (IN3, IN4),
   wobei der i-te Integrator einer Reihenschaltung als Eingangssignal ein Summensignal aus seinem über einen ersten Rückkopplungszweig zurückgeführten Ausgangssignal, dem über einen zweiten Rückkopplungszweig zurückgeführten Ausgangssignal des i-ten Integrators der anderen Reihenschaltung und einem dritten Signal empfängt,
   wobei das dritte Signal für den ersten Integrator (IN1, IN3) einer Reihenschaltung dem Ausgangssignal des letzten Integrators (IN2, IN4) der anderen Reihenschaltung und für die übrigen Integratoren dem Ausgangssignal des vorhergehenden Integrators derselben Reihenschaltung entspricht, und
   wobei an den Ausgängen der einzelnen Integratoren (IN1 - IN4) der ersten und zweiten Reihenschaltung zueinander phasenverschobene Ausgangssignale abgreifbar sind.

2. Schaltungsanordnung nach Anspruch 1,
   **dadurch gekennzeichnet,**
   **daß** den ersten Rückkopplungszweigen ein gemeinsamer erster Verstärkungsfaktor K1 und den zweiten Rückkopplungszweigen ein gemeinsamer zweiter Verstärkungsfaktor K2 zugeordnet ist,
   wobei der erste Verstärkungsfaktor K1 und der zweite Verstärkungsfaktor K2 derart gewählt sind, daß sie folgende Ungleichungs erfüllen: K2>K1, K2-K1<1 und K1+K2>1.

3. Schaltungsanordnung nach Anspruch 1 oder 2,
   **dadurch gekennzeichnet,**
   **daß** n=2 ist, wobei an den Ausgängen der einzelnen Integratoren (IN1 - IN4) der ersten und zweiten Reihenschaltung vier um jeweils 90° zueinander phasenverschobene und im wesentlichen sinusförmige Ausgangssignale abgreifbar sind.

4. Schaltungsanordnung nach einem der Ansprüche 1 - 3,
   **dadurch gekennzeichnet,**
   **daß** die Integratoren (IN1 - IN4) der ersten und zweiten Reihenschaltung hinsichtlich ihrer Übertragungskennlinie, Stromaufnahme und/oder maximalen Schaltfrequenz steuerbar sind.

**5.** Schaltungsanordnung nach einem der vorhergehenden Ansprüche,
**dadurch gekennzeichnet**
**daß** jeder Integrator (IN1 - IN4) in Form eines über mehrere Steuersignale (VP, VPP, VNN, VN) steuerbaren Inverters aufgebaut ist.

**6.** Schaltungsanordnung nach Anspruch 5,
**dadurch gekennzeichnet,**
**daß** jeder Integrator (IN1 - IN4) steuerbare Widerstände umfaßt, über die der Ausgangsstrom des jeweiligen Integrators einstellbar ist.

**7.** Schaltungsanordnung nach Anspruch 6,
**dadurch gekennzeichnet,**
**daß** die steuerbaren Widerstände durch wahlweise parallel oder in Serie miteinander verschaltbare Feldeffekttransistoren (MP1 - MP3, MN1 - MN3) gebildet sind.

**8.** Schaltungsanordnung nach einem der Ansprüche 5 - 7,
**dadurch gekennzeichnet,**
**daß** jeder Integrator (IN1 - IN4) abhängig von den Steuersignalen steuerbare Transistoren (MP4, MP5, MN4, MN5) umfaßt, welche zur Einstellung der übertragungskennlinie und Stromentnahme den Stromfluß über den jeweiligen Integrator steuern.

**9.** Schaltungsanordnung nach einem der Ansprüche 5 - 8,
**dadurch gekennzeichnet,**
**daß** jeder steuerbare Integrator (IN1 - IN4) umfaßt:

einen positiven Versorgungsspannungsanschluß (VDD) und einen negativen Versorgungsspannungsanschluß (VSS),
einen ersten Eingangsanschluß (EIN1) zum Empfangen des dritten Signals, einen zweiten Eingangsanschluß (EIN2) zum Empfangen des zurückgeführten Ausgangssignals des entsprechenden Integrators der anderen Reihenschaltung,
einen ersten und zweiten Steueranschluß (VP, VN) zum Empfangen eines ersten bzw. zweiten Steuersignals,
einen Ausgangsanschluß (AUS) zum Ausgeben eines Ausgangssignals, und
erste bis zehnte Transistoren (MP1 - MP5, MN1 - MN5),

wobei eine Serienschaltung aus den Hauptstrompfaden des ersten und vierten Transistors (MP1, MP4) zwischen den positiven Versorgungsspannungsanschluß (VDD) und den Ausgangsanschluß (AUS) geschaltet ist,
wobei der Steueranschluß des ersten Transistors (MP1) mit dem ersten Eingangsanschluß (EIN1) und der Steueranschluß des vierten Transistors (MP4) mit dem ersten Steueranschluß (VP) verbunden ist,
wobei eine Serienschaltung aus den Hauptstrompfaden des zweiten, dritten und fünften Transistors (MP2, MP3, MP5) parallel zu der Serienschaltung aus dem ersten und vierten Transistor (MP1, MP4) geschaltet ist,
wobei der Steueranschluß des zweiten Transistors (MP2) mit dem zweiten Eingangsanschluß (EIN2), der Steueranschluß des dritten Transistors (MP3) mit dem Ausgangsanschluß (AUS) und der Steueranschluß des fünften Transistors (MP5) mit dem ersten Steueranschluß (VP) verbunden ist, und
wobei die sechsten bis zehnten Transistoren (MN1 - MN5) mit dem negativen Versorgungsspannungsanschluß (VSS), dem zweiten Steueranschluß (VN), den Eingangsanschlüssen (EIN1, EIN2) und dem Ausgangsanschluß (AUS) spiegelsymmetrisch zu den ersten bis fünften Transistoren (MP1 - MP5) verschaltet sind.

**10.** Schaltungsanordnung nach Anspruch 9,
**dadurch gekennzeichnet,**
**daß** die ersten bis fünften Transistoren (MP1 - MP5) p-Kanal-Feldeffekttransistoren und die sechsten bis zehnten Transistoren (MN1 - MN5) n-Kanal-Feldeffekttransistoren sind.

**11.** Schaltungsanordnung nach Anspruch 9 oder 10,
**dadurch gekennzeichnet,**
**daß** jeder steuerbare Integrator (IN1 - IN4) des weiteren einen dritten und vierten Steueranschluß (VPP, VNN) zum Empfangen eines dritten bzw. vierten Steuersignals sowie einen elften und zwölften Transistor (MP6, MN6) umfaßt, wobei der elfte Transistor mit seinem Hauptstrompfad zwischen die Serienschaltung aus dem ersten und vierten Transistor (MP1, MP4) und dem Ausgangsanschluß (AUS) geschaltet ist und der Steueranschluß des elften Transistors (MP6) mit dem dritten Steueranschluß (VPP) verbunden ist, und

wobei der zwölfte Transistor (MN6) mit seinem Hauptstrompfad zwischen eine Serienschaltung aus dem sechsten und zehnten Transistor (MN1, MN4) und dem Ausgangsanschluß (AUS) geschaltet ist und der Steueranschluß des zwölften Transistors (MN6) mit dem vierten Steueranschluß (VNN) verbunden ist.

12. Schaltungsanordnung nach einem der Ansprüche 9 - 11
**dadurch gekennzeichnet,**
**daß** der erste Transistor (MP1) und der sechste Transistor (MN1) jeweils durch zwei in Serie geschaltete Transistoren (MP1A, MP1B; MN1A, MN1B) mit gemeinsamen Steueranschlüssen gebildet sind.

13. Schaltungsanordnung nach einem der Ansprüche 4 - 12
**dadurch gekennzeichnet,**
**daß** die Schaltungsanordnung eine Steuerschaltung zum Erzeugen von gemeinsamen Steuersignalen (VP, VPP, VNN, VN) abhängig von einem der Schaltungsanordnung extern zugeführten zentralen Steuersignal (VCO) umfaßt, wobei das extern zugeführte zentrale Steuersignal (VCO) die Schaltfrequenz der Integratoren (IN1 - IN4) definiert.

14. Schaltungsanordnung nach Anspruch 13 und Anspruch 11 oder 12,
**dadurch gekennzeichnet,**
**daß** die Steuerschaltung zur Erzeugung der gemeinsamen Steuersignale (VP, VPP, VNN, VN) umfaßt:

einen positiven Versorgungsspannungsanschluß und einen negativen Versorgungsspannungsanschluß,
einen Eingangsanschluß (VCO) zum Empfangen des extern zugeführten zentralen Steuersignals,
vier Ausgangsanschlüsse (VPP, VP, VN, VNN) zum Ausgeben des ersten, zweiten, dritten bzw. vierten Steuersignals für die steuerbaren Integratoren (IN1 - IN4),
zwei Stromquellen (I3, I4), und
erste bis vierzehnte Transistoren (MN13 - MN20, MP13 - MP18),

wobei eine Serienschaltung aus der einen Stromquelle (I3) und den Hauptstrompfaden des ersten und zweiten Transistors (MN19, MN13) zwischen den positiven Versorgungsspannungsanschluß (VDD) und den negativen Versorgungsspannungsanschluß (VSS) geschaltet ist,
wobei eine Serienschaltung der Hauptstrompfade des dritten und vierten Transistors (MP13, MP19) sowie der anderen Stromquelle (14) zwischen den positiven und den negativen Versorgungsspannungsanschluß (VDD; VSS) geschaltet ist,
wobei eine Serienschaltung der Hauptstrompfade des fünften und sechsten Transistors (MN20, MN18) zwischen den positiven und den negativen Versorgungsspannungsanschluß (VDD, VSS) geschaltet ist,
wobei eine Serienschaltung der Hauptstrompfade des siebten bis vierzehnten Transistors (MP14 - MP17, MN14 - MN17) zwischen den positiven und den negativen Versorgungsspannungsanschluß (VDD, VSS) geschaltet ist,
wobei der Steueranschluß des zwölften Transistors (MN15) mit dem Eingangsanschluß (VCO) und dem zweiten Ausgangsanschluß (VN) der Steuerschaltung verbunden ist,
wobei der Steueranschluß des neunten Transistors (MP15) mit dem ersten Ausgangsanschluß (VP) der Steuerschaltung verbunden ist, wobei der Steueranschluß des elften Transistors (MN14) mit dem zwischen die eine Stromquelle (13) und die Serienschaltung des ersten und zweiten Transistors (MN19, MN13) angeschlossenen dritten Ausgangsanschluß (VNN) der Steuerschaltung verbunden ist, und
wobei der Steueranschluß des zehnten Transistors (MP14) mit dem zwischen die andere Stromquelle (14) und die Serienschaltung des dritten und vierten Transistors (MP13, MP19) angeschlossenen vierten Ausgangsanschluß (VPP) der Steuerschaltung verbunden ist.

15. Schaltungsanordnung nach Anspruch 14,
**dadurch gekennzeichnet,**
**daß** die ersten, zweiten, fünften, sechsten und elften bis vierzehnten Transistoren (MN13 - MN20) n-Kanal-Feldeffekttransistoren und die dritten, vierten und siebten bis zehnten Transistoren (MP13 - MP18) p-Kanal-Feldeffekttransistoren sind.

16. Schaltungsanordnung nach einem der vorhergehenden Ansprüche
**dadurch gekennzeichnet,**
**daß** die Ausgangssignale der Integratoren (IN1 - IN4) über steuerbare Treiber (TR1 - TR4) geführt sind, deren Flankensteilheiten einstellbar sind.

**17.** Schaltungsanordnung nach Anspruch 16 und Anspruch 14 oder 15,
**dadurch gekennzeichnet,**
**daß** jeder steuerbare Treiber (TR1 - TR4) umfaßt:

einen Eingangsanschluß (EIN) zum Empfangen des Ausgangssignals des entsprechenden Integrators (IN1 - IN4),
einen Ausgangsanschluß (AUS) zum Ausgeben eines Ausgangssignals,
einen ersten und zweiten Steueranschluß (VP, VN) zum Empfangen des ersten bzw. zweiten Steuersignales der Steuerschaltung,
einen positiven und einen negativen Versorgungsspannungsanschluß (VDD, VSS), und
erste bis zwölfte Transistoren (MP7 - MP12, MN7 - MN12),

wobei eine Serienschaltung der Hauptstrompfade der ersten bis dritten Transistoren (MP7 - MP10) an dem positiven Versorgungsspannungsanschluß (VDD) angeschlossen ist,
wobei eine Serienschaltung der Hauptstrompfade der fünften und sechsten Transistoren (MP11, MP12) zwischen den positiven Versorgungsspannungsanschluß (VDD) und den Ausgangsanschluß (AUS) geschaltet ist,
wobei der vierte Transistor (MP9) mit seinem Hauptstrompfad an einem Knotenpunkt zwischen dem zweiten und dritten Transistor (MP8, MP10) angeschlossen ist,
wobei der Steueranschluß des ersten Transistors (MP7) an den Eingangsanschluß (EIN) angeschlossen ist, die Steueranschlüsse des zweiten, dritten und sechsten Transistors (MP8, MP10, MP12) an den ersten Steueranschluß (VP) angeschlossen sind, und die Steueranschlüsse des vierten und fünften Transistors (MP9, MP11) miteinander verbunden sind, und
wobei die siebten bis zwölften Transistoren (MN7 - MN12) mit dem Eingangsanschluß (EIN), dem Ausgangsanschluß (AUS), dem zweiten Steueranschluß (VN) und dem negativen Versorgungsspannungsanschluß (VSS) derart spiegelsymmetrisch zu den ersten bis sechsten Transistoren (MP7 - MP12) verschaltet sind, daß der dritte Transistor (MP10) mit dem zehnten Transistor (MN9) und der neunte Transistor (MN10) mit dem vierten Transistor (MP9) gekoppelt ist.

**18.** Schaltungsanordnung nach Anspruch 17,
**dadurch gekennzeichnet,**
**daß** die ersten bis sechsten Transistoren (MP7 - MP12) p-Kanal-Feldeffekttransistoren und die siebten bis zwölften Transistoren (MN7 - MN12) n-Kanal-Feldeffekttransistoren sind.

**19.** Spannungsreglerschaltung,
mit einem Eingangsanschluß zum Empfangen einer Eingangsspannung ($U_e$) ,
mit einem Ausgangsanschluß zum Bereitstellen einer geregelten Ausgangsspannung ($U_a$) ,
mit einem Transistor (T), dessen Hauptstrompfad zwischen den Eingangsanschluß und den Ausgangsanschluß geschaltet ist,
mit einem Regelverstärker (RV), der an einem Eingangsanschluß die geregelte Ausgangsspannung ($U_a$) empfängt und an einem Ausgangsanschluß ein Steuersignal (VCO) bereitstellt,
mit einem Kondensator (C1), der zwischen den Steueranschluß des Transistor (T) und den Ausgangsanschluß des Regelverstärkers (RV) geschaltet ist,
mit einer steuerbaren Stromquelle (I) zum Entladen des Kondensators (C1), und
mit einer Ladungspumpe (LP), die eine Schaltungsanordnung nach einem der Ansprüche 1 bis 18 umfaßt und die eine durch den Regelverstärker (RV) steuerbare Spannung an den Steuranschluß des Transistors (T) anlegt,
wobei daß die Schaltfrequenz der Ladungspumpe (LP) abhängig von dem Steuersignal (VCO) des Regelverstärkers (RV) veränderbar ist.

**20.** Spannungsreglerschaltung nach Anspruch 19,
**dadurch gekennzeichnet,**
**daß** der Transistor (T) ein DMOS-Feldeffekttransistor ist.

**21.** Spannungsreglerschaltung nach Anspruch 19 oder 20,
**dadurch gekennzeichnet,**
**daß** der Regelverstärker (RV) ein Class-B-Verstärker mit geringem Ruhestrom ist.

**22.** Spannungsreglerschaltung nach Anspruch 21,
**dadurch gekennzeichnet,**

**daß** eine weitere Stromquelle (I2) mit dem Steueranschluß des Transistors (T) gekoppelt ist,

**daß** der Regelverstärker (RV) bei einer Eingangsspannung bestimmter Größe ein der Schaltfrequenz Null entsprechendes Steuersignal (VCO) für die Ladungspumpe (LP) erzeugt, und

**daß** die weitere Stromquelle (I2) derart ausgestaltet und angeordnet ist, daß sie auch bei dem der Schaltfrequenz Null entsprechenden Steuersignal (VCO) des Regelverstärkers (RV) eine ausreichend hohe Steuerladung für den Steueranschluß des Transistors (T) aufrechterhält.

**Claims**

1. Circuit arrangement for a charge pump,
   having
   a first series circuit of n integrators (IN1, IN2) and a second series circuit of n further integrators (IN3, IN4),
   the ith integrator of a series circuit receiving, as input signal, a summation signal comprising its output signal fed back via a first feedback path, the output signal of the ith integrator of the other series circuit fed back via a second feedback path and a third signal, the first signal corresponding, for the first integrator (IN1, IN3) of a series circuit, to the output signal of the last integrator (IN2, IN4) of the other series circuit and, for the remaining integrators, to the output signal of the preceding integrator of the said series circuit, and
   it being possible for output signals which are phase-shifted with respect to one another to be picked off at the outputs of the individual integrators (IN1 - IN4) of the first and second series circuits.

2. Circuit arrangement according to Claim 1,
   **characterized**
   **in that** the first feedback paths are assigned a common first gain factor K1 and the second feedback paths are assigned a common second gain factor K2,
   the first gain factor K1 and the second gain factor K2 being chosen in such a way that they fulfil the following inequality: K2>K1, K2-K1<1 and K1+K2>1.

3. Circuit arrangement according to Claim 1 or 2,
   **characterized**
   **in that** n=2, it being possible for four essentially sinusoidal output signals which are phase-shifted by in each case 90° with respect to one another to be picked off at the outputs of the individual integrators (IN1 - IN4) of the first and second series circuits.

4. Circuit arrangement according to one of Claims 1 - 3,
   **characterized**
   **in that** the integrators (IN1 - IN4) of the first and second series circuits are controllable with regard to their transfer characteristic, current consumption and/or maximum switching frequency.

5. Circuit arrangement according to one of the preceding claims,
   **characterized**
   **in that** each integrator (IN1 - IN4) is constructed in the form of an inverter which can be controlled by means of a plurality of control signals (VP, VPP, VNN, VN).

6. Circuit arrangement according to Claim 5,
   **characterized**
   **in that** each integrator (IN1 - IN4) comprises controllable resistors by means of which the output current of the respective integrator can be set.

7. Circuit arrangement according to Claim 6,
   **characterized**
   **in that** the controllable resistors are formed by field-effect transistors (MP1 - MP3, MN1 - MN3) which can optionally be connected up in parallel or in series with one another.

8. Circuit arrangement according to one of Claims 5 - 7,
   **characterized**
   **in that** each integrator (IN1 - IN4) comprises transistors (MP4, MP5, MN4, MN5) which can be controlled depending on the control signals and control the current flow via the respective integrator for the purpose of setting the transfer characteristic and the current drawn.

9.  Circuit arrangement according to one of Claims 5 - 8,
    **characterized**
    **in that** each controllable integrator (IN1 - IN4) comprises:

    a positive supply voltage terminal (VDD) and a negative supply voltage terminal (VSS),
    a first input terminal (IN1) for receiving the third signal, a second input terminal (IN2) for receiving the fed-back output signal of the corresponding integrator of the other series circuit,
    a first and second control terminal (VP, VN) for receiving a first and second control signal, respectively,
    an output terminal (OUT) for outputting an output signal, and first to tenth transistors (MP1 - MP5, MN1 - MN5),
    a series circuit formed by the main current paths of the first and fourth transistors (MP1, MP4) being connected between the positive supply voltage terminal (VDD) and the output terminal (OUT),
    the control terminal of the first transistor (MP1) being connected to the first input terminal (IN1) and the control terminal of the fourth transistor (MP4) being connected to the first control terminal (VP),
    a series circuit formed by the main current paths of the second, third and fifth transistors (MP2, MP3, MP5) being connected in parallel with the series circuit formed by the first and fourth transistors (MP1, MP4),
    the control terminal of the second transistor (MP2) being connected to the second input terminal (IN2), the control terminal of the third transistor (MP3) being connected to the output terminal (OUT) and the control terminal of the fifth transistor (MP5) being connected to the first control terminal (VP), and
    the sixth to tenth transistors (MN1 - MN5) being connected up to the negative supply voltage terminal (VSS), the second control terminal (VN), the input terminals (IN1, IN2) and the output terminal (OUT) in a mirror-symmetrical manner with respect to the first to fifth transistors (MP1 - MP5).

10. Circuit arrangement according to Claim 9,
    **characterized**
    **in that** the first to fifth transistors (MP1 - MP5) are p-channel field-effect transistors and the sixth to tenth transistors (MN1 - MN5) are n-channel field-effect transistors.

11. Circuit arrangement according to Claim 9 or 10,
    **characterized**
    **in that** each controllable integrator (IN1 - IN4) furthermore comprises a third and fourth control terminal (VPP, VNN) for receiving a third and fourth control signal, respectively, as well as an eleventh and twelfth transistor (MP6, MN6), the eleventh transistor being connected by its main current path between the series circuit formed by the first and fourth transistor (MP1, MP4) and the output terminal (OUT), and the control terminal of the eleventh transistor (MP6) being connected to the third control terminal (VPP), and
    the twelfth transistor (MN6) being connected by its main current path between a series circuit formed by the sixth and tenth transistors (MN1, MN4) and the output terminal (OUT) and the control terminal of the twelfth transistors (MN6) being connected to the fourth control terminal (VNN).

12. Circuit arrangement according to one of Claims 9 - 11,
    **characterized**
    **in that** the first transistor (MP1) and the sixth transistor (MN1) are formed in each case by two series-connected transistors (MP1A, MP1B; MN1A, MN1B) with common control terminals.

13. Circuit arrangement according to one of Claims 4 - 12,
    **characterized**
    **in that** the circuit arrangement comprises a control circuit for generating common control signals (VP, VPP, VNN, VN) depending on a central control signal (VCO) fed in externally to the circuit arrangement, the central control signal (VCO) fed in externally defining the switching frequency of the integrators (IN1 - IN4).

14. Circuit arrangement according to Claim 13 and Claim 11 or 12,
    **characterized**
    **in that** the control circuit for generating the common control signals (VP, VPP, VNN, VN) comprises:

    a positive supply voltage terminal and a negative supply voltage terminal,
    an input terminal (VCO) for receiving the central control signal which is fed in externally,
    four output terminals (VPP, VP, VN, VNN) for outputting the first, second, third and fourth control signal, respectively, for the controllable integrators (IN1 - IN4),

two current sources (I3, I4), and

first to fourteenth transistors (MN13 - MN20, MP13 - MP18), a series circuit formed by one current source (I3) and the main current paths of the first and second transistors (MN19, MN13) being connected between the positive supply voltage terminal (VDD) and the negative supply voltage terminal (VSS) ,

a series circuit formed by the main current paths of the third and fourth transistors (MP13, MP19) and the other current source (14) being connected between the positive and negative supply voltage terminals (VDD, VSS),

a series circuit formed by the main current paths of the fifth and sixth transistors (MN20, MN18) being connected between the positive and negative supply voltage terminals (VDD, VSS),

a series circuit formed by the main current paths of the seventh to fourteenth transistors (MP14 - MP17, MN14 - MN17) being connected between the positive and negative supply voltage terminals (VDD, VSS),

the control terminal of the twelfth transistor (MN15) being connected to the input terminal (VCO) and the second output terminal (VN) of the control circuit,

the control terminal of the ninth transistor (MP15) being connected to the first output terminal (VP) of the control circuit, the control terminal of the eleventh transistor (MN14) being connected to the third output terminal (VNN) of the control circuit, which third output terminal is connected between the one current source (I3) and the series circuit of the first and second transistors (MN19, MN13), and

the control terminal of the tenth transistor (MP14) being connected to the fourth output terminal (VPP) of the control circuit, which fourth output terminal is connected between the other current source (I4) and the series circuit of the third and fourth transistors (MP13, MP19).

15. Circuit arrangement according to Claim 14,
    **characterized**
    **in that** the first, second, fifth, sixth and eleventh to fourteenth transistors (MN13 - MN20) are n-channel field-effect transistors and the third, fourth and seventh to tenth transistors (MP13 - MP18) are p-channel field-effect transistors.

16. Circuit arrangement according to one of the preceding claims,
    **characterized**
    **in that** the output signals of the integrators (IN1 - IN4) are passed via controllable drivers (TR1 - TR4), whose edge steepnesses are adjustable.

17. Circuit arrangement according to Claim 16 and Claim 14 of 15,
    **characterized**
    **in that** each controllable driver (TR1 - TR4) comprises:

    an input terminal (IN) for receiving the output signal of the corresponding integrator (IN1 - IN4),

    an output terminal (OUT) for outputting an output signal,

    a first and second control terminal (VP, VN) for receiving the first and second control signal, respectively, of the control circuit,

    a positive and a negative supply voltage terminal (VDD, VSS), and

    first to twelfth transistors (MP7 - MP12, MN7 - MN12),

    a series circuit formed by the main current paths of the first to third transistors (MP7 - MP10) being connected to the positive supply voltage terminal (VDD),

    a series circuit formed by the main current paths of the fifth and sixth transistors (MP11, MP12) being connected between the positive supply voltage terminal (VDD) and the output terminal (OUT),

    the fourth transistor (MP9) being connected by its main current path to a node between the second and third transistors (MP8, MP10),

    the control terminal of the first transistor (MP7) being connected to the input terminal (IN), the control terminals of the second, third and sixth transistors (MP8, MP10, MP12) being connected to the first control terminal (VP), and the control terminals of the fourth and fifth transistors (MP9, MP11) being connected to one another, and

    the seventh to twelfth transistors (MN7 - MN12) being connected up to the input terminal (IN), the output terminal (OUT), the second control terminal (VN) and the negative supply voltage terminal (VSS) mirror-symmetrically with respect to the first to sixth transistors (MP7 - MP12) in such a way that the third transistor (MP10) is coupled to the tenth transistor (MN9) and the ninth transistor (MN10 is coupled to the fourth transistor (MP9).

18. Circuit arrangement according to Claim 17,
    **characterized**
    **in that** the first to sixth transistors (MP7 - MP12) are p-channel field-effect transistors and the seventh to twelfth transistors (MN7 - MN12) are n-channel field-effect transistors.

19. Voltage regulator circuit,
   having an input terminal for receiving an input voltage (Ue), having an output terminal for providing a regulated output voltage (Ua),
   having a transistor (T), whose main current path is connected between the input terminal and the output terminal,
   having a regulating amplifier (RV) which receives the regulated output voltage (Ua) at an input terminal and provides a control signal (VCO) at an output terminal,
   having a capacitor (C1), which is connected between the control terminal of the transistor (T) and the output terminal of the regulating amplifier (RV), having a controllable current source (I1) for discharging the capacitor (C1) and having a charge pump (LP), which comprises a circuit arrangement according to one of Claims 1 to 18 and which applies a voltage that can be controlled by the regulating amplifier (RV) to the control terminal of the transistor (T), in which the switching frequency of the charge pump (LP) can be altered depending on the control signal (VCO) of the regulating amplifier (RV).

20. Voltage regulator circuit according to Claim 19,
   **characterized**
   **in that** the transistor (T) is a DMOS field-effect transistor.

21. Voltage regulator circuit according to Claim 19 or 20,
   **characterized**
   **in that** the regulating amplifier (RV) is a Class B amplifier with a low quiescent current.

22. Voltage regulator circuit according to Claim 21,
   **characterized**
   **in that** a further current source (I2) is coupled to the control terminal of the transistor (T),
   **in that**, given an input voltage of specific magnitude, the regulating amplifier (RV) generates a control signal (VCO) for the charge pump (LP), which control signal corresponds to the switching frequency zero, and
   **in that** the further current source (I2) is configured and arranged in such a way that it maintains a sufficiently high control charge for the control terminal of the transistor (T) even in the case of the control signal (VCO) of the regulating amplifier (RV) which corresponds to the switching frequency zero.

**Revendications**

1. Circuit pour une pompe de charge, avec un premier montage en série de n intégrateurs (IN1, IN2) et un deuxième montage en série de n autres intégrateurs (IN3, IN4),
   le i-ième intégrateur d'un montage en série recevant en tant que signal d'entrée un signal composite composé de son signal de sortie ramené par une première branche de retour, du signal de sortie du ixième intégrateur de l'autre montage en série ramené par une deuxième branche de retour et d'un troisième signal, le troisième signal pour le premier intégrateur (IN1, IN3) d'un montage en série correspondant au signal de sortie du dernier intégrateur (IN2, IN4) de l'autre montage en série et pour les autres intégrateurs, au signal de sortie de l'intégrateur précédent du même montage en série, et
   des signaux de sortie à phase décalée les uns par rapport aux autres pouvant être prélevés au niveau des sorties des différents intégrateurs (IN à IN4) des premier et deuxième montages en série.

2. Circuit selon la revendication 1,
   **caractérisé en ce que**
   la première branche de retour est associée à un premier facteur d'amplification commun K1 et la deuxième branche de retour à un deuxième facteur d'amplification K2 commun, le premier facteur d'amplification K1 et le deuxième facteur d'amplification K2 étant sélectionnés de manière à satisfaire les inéquations suivantes : K2>K1, K2-K1<1 et K1+K2>1.

3. Circuit selon la revendication 1 ou 2,
   **caractérisé en ce que**
   n = 2, quatre signaux de sortie essentiellement sinusoïdaux et chacun à phase décalée de 90° les uns par rapport aux autres pouvant être prélevés au niveau des sorties des différents intégrateurs (IN 1 à IN4) des premier et deuxième montages en série.

**4.** Circuit selon l'une quelconque des revendications 1 à 3,
**caractérisé en ce que**
les intégrateurs (IN à IN4) des premier et deuxième montages en série peuvent être commandés en ce qui concerne leur ligne caractéristique de transmission, l'absorption de courant et/ou la fréquence de commutation maximale.

**5.** Circuit selon l'une quelconque des revendications précédentes,
**caractérisé en ce que**
chaque intégrateur (IN 1 à IN4) est un inverseur pouvant être commandé par plusieurs signaux de commande (VP, VPP, VNN, VN).

**6.** Circuit selon la revendication 5,
**caractérisé en ce que**
chaque intégrateur (IN1 à IN4) comprend des résistances pouvant être commandées pour régler le courant de sortie de chaque intégrateur.

**7.** Circuit selon la revendication 6,
**caractérisé en ce que**
les résistances commandables sont formées par des transistors à effet de champ (MP1 à MP3, MN1 à MN3) pouvant être connectés au choix en série ou en parallèle les uns avec les autres.

**8.** Circuit selon l'une quelconque des revendications 5 à 7,
**caractérisé en ce que**
chaque intégrateur (IN1 à IN4) comprend des transistors (MP4, MP5, MN4, MN5) pouvant être commandés en fonction des signaux de commande, ces transistors commandant par l'intégrateur respectif le courant électrique pour le réglage de la ligne caractéristique de transmission et la consommation de courant.

**9.** Circuit selon l'une quelconque des revendications 5 à 8,
**caractérisé en ce que**
chaque intégrateur pouvant être commandé (IN 1 à IN4) comporte :

une borne de tension d'alimentation positive (VDD) et une borne de tension d'alimentation négative (VSS),
une première borne d'entrée (EIN1) pour recevoir le troisième signal, une deuxième borne d'entrée (EIN2) pour recevoir le signal de sortie ramené de l'intégrateur correspondant de l'autre montage en série,
une première et une deuxième bornes de commande (VP, VN) pour recevoir un premier et/ ou un deuxième signal de commande,
une borne de sortie (AUS) pour délivrer un signal de sortie, et
un premier jusqu'à un dixième transistors (MP1 à MP5, MN1 à MN5),
un montage en série réalisé à partir des trajectoires de courant principal des premier et quatrième transistors (MP1, MP4) étant intercalé entre la borne de tension d'alimentation positive (VDD) et la borne de sortie (AUS),
la borne de commande du premier transistor (MP1) étant reliée à la première borne d'entrée (EIN 1 ) et la borne de commande du quatrième transistor (MP4) à la première borne de commande (VP),
un montage en série réalisé à partir des trajectoires de courant principal des deuxième, troisième et cinquième transistors (MP2, MP3, MP5) étant connecté en parallèle au montage en série réalisé à partir des premier et quatrième transistors (MP1, MP4),
la borne de commande du deuxième transistor (MP2) étant reliée à la deuxième borne d'entrée (EIN2), la borne de commande du troisième transistor (MP3) à la borne de sortie (AUS) et la borne de commande du cinquième transistor (MP5) à la première borne de commande (VP), et
les sixième au dixième transistors (MN1 à MN5) étant connectés à la borne de tension d'alimentation négative (VSS), à la deuxième borne de commande (VN), aux bornes d'entrée (EIN1, EIN2) et à la borne de sortie (AUS) symétriquement par effet de miroir par rapport aux premier jusqu'au cinquième transistors (MP1 à MP5).

**10.** Circuit selon la revendication 9,
**caractérisé en ce que**
les premier au cinquième transistors (MP1 à MP5) sont des transistors à effet de champ à canal p et les sixième au dixième transistors (MN 1 à MN5) sont des transistors à effet de champ à canal n.

**11.** Circuit selon la revendication 9 ou 10,
**caractérisé en ce que**

chaque intégrateur pouvant être commandé (IN1 à IN4) comporte en outre une troisième et une quatrième bornes de commande (VPP, VNN) pour recevoir un troisième et/ou un quatrième signal de commande ainsi qu'un onzième et un douzième transistors (MP6, MN6),

le onzième transistor avec sa trajectoire de courant principal étant intercalé entre le montage en série réalisé à partir des premier et quatrième transistors (MP1, MP4) et la borne de sortie (AUS) et la borne de commande du onzième transistor (MP6) étant reliée à la troisième borne de commande (VPP), et

le douzième transistor (MN6) avec sa trajectoire de courant principal étant intercalé entre un montage en série réalisé à partir des sixième et dixième transistors (MN1, MN4) et la borne de sortie (AUS), et la borne de commande du douzième transistor (MN6) étant reliée à la quatrième borne de commande (VNN).

12. Circuit selon l'une quelconque des revendications 9 à 11,
    **caractérisé en ce que**
    le premier transistor (MP1) et le sixième transistor (MN1) sont chacun formés par deux transistors (MP1A, MP1B ; MN1A, MN1B) montés en série avec des bornes de commande communes.

13. Circuit selon l'une quelconque des revendications 4 à 12,
    **caractérisé en ce que**
    le dispositif de circuit comporte un circuit de commande pour produire des signaux de commande communs (VP, VPP, VNN, VN) en fonction d'un signal de commande central (VCO) amené en externe au dispositif de circuit, le signal de commande central (VOC) amené en externe définissant la fréquence de commutation des intégrateurs (IN 1 à IN4).

14. Circuit selon la revendication 13 et la revendication 11 ou 12,
    **caractérisé en ce que**
    le circuit de commande pour produire les signaux de commande communs (VP, VPP, VNN, VN) comporte :

    une borne de tension d'alimentation positive et une borne de tension d'alimentation négative,
    une borne d'entrée (VCO) pour recevoir le signal de commande central amené en externe,
    quatre bornes de sortie (VPP, VP, VN, VNN) pour délivrer les premier, deuxième, troisième et/ou quatrième signaux de commande pour les intégrateurs pouvant être commandés (IN 1 à IN4),
    deux sources de courant (I3, I4), et
    un premier jusqu'à un quatorzième transistors (MN 13 à MN20, MP 13 à MP18),
    un montage en série réalisé à partir d'une source de courant (I3) et des trajectoires de courant principal des premier et deuxième transistors (MN19, MN13) étant intercalé entre la borne de tension d'alimentation positive (VDD) et la borne de tension d'alimentation négative (VSS), et
    un montage en série des trajectoires de courant principal des troisième et quatrième transistors (MP13, MP19) ainsi que de l'autre source de courant (14) étant intercalé entre les bornes de tension d'alimentation positive et négative (VDD ; VSS),
    un montage en série des trajectoires de courant principal des cinquième et sixième transistors (MN20, MN18) étant intercalé entre les bornes de tension d'alimentation positive et négative (VDD, VSS),
    un montage en série des trajectoires de courant principal des septième jusqu'au quatorzième transistors (MP14 à MP17, MN14 à MN17) étant intercalé entre les bornes de tension d'alimentation positive et négative (VDD, VSS),
    la borne de commande du douzième transistor (MN 15) étant reliée à la borne d'entrée (VCO) et à la deuxième borne de sortie (VN) du circuit de commande,
    la borne de commande du neuvième transistor (MP15) étant reliée à la première borne de sortie (VP) du circuit de commande, la borne de commande du onzième transistor (MN14) étant reliée à la troisième borne de sortie (VNN) du circuit de commande raccordée entre une source de courant (I3) et le circuit de commande des premier et deuxième transistors (MN19, MN13), et
    la borne de commande du dixième transistor (MP14) étant reliée à la quatrième borne de sortie (VPP) du circuit de commande raccordée entre l'autre source de courant (I4) et le circuit de commande des troisième et quatrième transistors (MP13, MP19).

15. Circuit selon la revendication 14,
    **caractérisé en ce que**
    les premier, deuxième, cinquième, sixième et onzième jusqu'au quatorzième transistors (MN13 à MN20)) sont des transistors à effet de champ à canal n et les troisième, quatrième et septième jusqu'au dixième transistors (MP13 à MP18) sont des transistors à effet de champ à canal p.

**16.** Circuit selon l'une quelconque des revendications précédentes,
**caractérisé en ce que**
les signaux de sortie des intégrateurs (IN1 à IN4) sont guidés par des circuits d'attaque pouvant être commandés (TR1 à TR4) avec des raideurs de flancs réglables.

**17.** Circuit selon la revendication 16 et la revendication 14 ou 15,
**caractérisé en ce que**
chaque circuit d'attaque pouvant être commandé (TR1 à TR4) comporte :

une borne d'entrée (EIN) pour recevoir le signal de sortie de l'intégrateur correspondant (IN1 à IN4),
une borne de sortie (AUS) pour délivrer un signal de sortie,
une première et une deuxième bornes de commande (VP, VN) pour recevoir le premier et/ou le deuxième signal de commande du circuit de commande,
une borne de tension d'alimentation positive et négative (VDD, VSS), et un premier jusqu'à un douzième transistors (MP7 à MP12, MN7 à MN12),
un montage en série des trajectoires de courant principal des premier jusqu'au troisième transistors (MP7 à MP10) étant raccordé à la borne de tension d'alimentation positive (VDD),
un montage en série des trajectoires de courant principal des cinquième et sixième transistors (MP11, MP12) étant intercalé entre la borne de tension d'alimentation positive (VDD) et la borne de sortie (AUS),
le quatrième transistor (MP9) avec sa trajectoire de courant principal étant raccordé à un point de noeud entre le deuxième et le troisième transistors (MP8, MP10),
la borne de commande du premier transistor (MP7) étant raccordée à la borne d'entrée (EIN), les bornes de commande des deuxième, troisième et sixième transistors (MP8, MP10, MP12) étant raccordées à la première borne de commande (VP), et les bornes de commande des quatrième et cinquième transistors (MP9, MP11) étant reliées entre elles, et
le septième jusqu'au douzième transistors (MN7 à MN12) étant connectés à la borne d'entrée (EIN), la borne de sortie (AUS), la deuxième borne de commande (VN) et la borne de tension d'alimentation négative (VSS) symétriquement par effet de miroir par rapport aux premier jusqu'au sixième transistors (MP7 à MP12) de telle sorte que le troisième transistor (MP10) est couplé au dixième transistor (MN9) et le neuvième transistor (MN10) au quatrième transistor (MP9).

**18.** Circuit selon la revendication 17,
**caractérisé en ce que**
les premier au sixième transistors (MP7 à MP12) sont des transistors à effet de champ à canal p et les septième au douzième transistors (MN7 à MN 12) sont des transistors à effet de champ à canal n.

**19.** Régulateur de tension,
avec une borne d'entrée pour recevoir une tension d'entrée ($U_e$),
avec une borne de sortie pour mettre à disposition une tension de sortie régulée ($U_a$), avec un transistor (T) dont la trajectoire de courant principal est intercalée entre la borne d'entrée et la borne de sortie,
avec un régulateur de tension (RV) qui reçoit au niveau d'une borne d'entrée la tension de sortie régulée ($U_a$) et met à disposition un signal de commande (VCO) au niveau d'une borne de sortie,
avec un condensateur (C1) qui est intercalé entre la borne de commande du transistor (T) et la borne de sortie de l'amplificateur régulateur (RV),
avec une source de courant pouvant être commandée (I) pour décharger le condensateur (C1), et
avec une pompe de charge (LP) qui comporte un circuit selon l'une quelconque des revendications 1 à 18 et qui applique au niveau de la sortie de commande du transistor (T) une tension pouvant être commandée par l'amplificateur régulateur (RV),
la fréquence de commutation de la pompe de charge (LP) étant modifiable en fonction du signal de commande (VCO) de l'amplificateur régulateur (RV).

**20.** Régulateur de tension selon la revendication 19,
**caractérisé en ce que**
le transistor (T) est un transistor DMOS à effet de champ.

**21.** Régulateur de tension selon la revendication 19 ou 20,
**caractérisé en ce que**
le régulateur de tension (RV) est un amplificateur de classe B avec un courant de repos faible.

**22.** Régulateur de tension selon la revendication 21,
**caractérisé en ce qu'**
une autre source de courant (12) est couplée à la borne de commande du transistor (T), l'amplificateur régulateur (RV) produit un signal de commande (VCO) correspondant à la fréquence de commutation zéro pour la pompe de charge (LP) dans le cas d'une tension d'entrée de grandeur définie, et l'autre source de courant (12) est conçue et disposée de telle sorte qu'elle maintient une charge de commande suffisamment élevée pour la borne de commande du transistor (T) même dans le cas du signal de commande (VCO) de l'amplificateur régulateur (RV) correspondant à la fréquence de commutation zéro.

**FIG 1**

$U_{LPe}$

LP

VCO-Ladungspumpe

VCO

$U_{LPa}$

T

$U_e$

$C_1$

$U_{ref}$

$I$

$C_2$

$U_a$

**FIG 2A**

$I_{LPe}$

$D_1$        $D_2$        $I_{LPa}$

$U_{LPe}$

Oszillator        Treiber

$C$

$C_S$

$U_{LPa}$

OSC        TR

**FIG 2B**

$I$

$I_{LPe}$

$I_{LPa}$

$U_{LPa}$

**FIG 2C**

$\eta$

$U_{LPa}$

EP 0 952 661 B1

FIG 3

20

**FIG 4**

**FIG 5**

FIG 6

FIG 7

## FIG 8
(Stand der Technik)

## FIG 9
(Stand der Technik)

# FIG 10
(Stand der Technik)